# EUROPÄISCHE PATENTSCHRIFT

(11) **EP 3 930 320 B1**
(45) Veröffentlichungstag und Bekanntmachung des Hinweises auf die Patenterteilung: **06.05.2026**
(21) Anmeldenummer: 21174783.7
(22) Anmeldetag: 19.05.2021
(51) Int. Cl.: H04N 9/31, H01S 5/0683, H01S 5/40, G01C 15/00, B23D 33/12

(54) **LASERPROJEKTOR MIT ZWEI LASERDIODEN**
LASER PROJECTOR WITH TWO LASER DIODES
PROJECTEUR LASER POURVU DE DEUX DIODES LASER

(30) Priorität: 26.06.2020 DE 102020116897
(43) Veröffentlichungstag der Anmeldung: 29.12.2021
(73) Patentinhaber: LAP GmbH Laser Applikationen, 21337 Lüneburg (DE)
(72) Erfinder: Werner, Hans-Peter, 21335 Lüneburg (DE); Lange, Matthias, 21483 Dalldorf (DE); Chow, Tze Keong, 486858 Singapur (SG)
(74) Vertreter: Hauck Patent- und Rechtsanwälte PartmbB

(56) Entgegenhaltungen:
- US-A1- 2016 073 071
- US-A1- 2016 087 393

## Beschreibung

Die vorliegende Erfindung betrifft eine Vorrichtung zur Laserprojektion, die zwei Laserdioden aufweist.

Laserprojektoren werden in den verschiedensten technischen Gebieten eingesetzt, um Umrisse und Markierungen auf Gegenstände zu projizieren. In der Regel können deren Linien in roter, grüner oder mehrfarbiger Projektion auf eine ebene oder gewölbte Fläche gut sichtbar projiziert werden. Als Grundlage für die Projektion dienen häufig CAD-Daten, die zu Projektionsdaten verarbeitet und an einen oder mehrere Projektoren übermittelt werden. Industrielle Laserprojektionssysteme erzeugen virtuelle, aber sichtbare Schablonen, die die Oberflächen nicht berühren oder verschmutzen. Technisch erfolgt die Projektion über eine oder mehrere Galvanometer, die mit jeweils einem Spiegel ausgestattet sind. Der Laserstrahl wird durch den Spiegel abgelenkt, wobei der Drehwinkel des Spiegels die Richtung der Ablenkung bestimmt. Werden zwei oder mehr Galvanometer miteinander kombiniert, so kann jeder zugängliche Punkt im Raum angestrahlt werden.

Aus DE 10 2019 217 801 A1 ist ein Laserprojektionssystem zum Projizieren eines Laserbildes auf eine Arbeitsoberfläche bekannt geworden, das eine optimierte Laserenergie bereitstellt, wobei eine Laserquelle und ein elektronischer Schaltkreis zum Modulieren eines Ausgangsleistungsniveaus vorgesehen sind. Eine Steuereinheit beinhaltet ein Abtastungspfadeingangsmodul zum Erzeugen einer Simulation der Winkelgeschwindigkeit des Abtastspiegels entlang dem Abtastpfad, um so eine Konzentration der Laserenergie entlang dem Abtastpfad abschätzen zu können. Der elektronische Schaltkreis moduliert eine Energiekonzentration des Laserstrahls abhängig von der Laserenergie und der Winkelgeschwindigkeit auf dem Abtastspiegel. Erreicht werden soll damit, dass auch bei hoher Geschwindigkeit ein stabiles, flackerfreies Bild entsteht.

Aus US 2019/0310539 A1 ist ein Laserprojektor mit zwei Laser-Licht-Quellen bekannt geworden. Die Laserquellen sind einander gegenüberliegend angeordnet und werden durch zwei Reflektoren miteinander kombiniert.

Aus US 2019/0237939 A1 ist ein kompakter Laserprojektor mit zwei Laserdioden bekannt geworden. Die beiden Laserdioden werden miteinander kombiniert, um so annähernd die Lichtstärke des Lasers zu verdoppeln. Über zwei Kollimator-Linsen und eine λ/2-Platte werden die beiden Laserstrahlen über einen Reflektor zusammengeführt. Der besondere Vorteil liegt hier in der kompakten Bauweise eines leistungsstarken Lasers.

Aus DE 10 2013 208 819 A1 ist eine Laserprojektionsvorrichtung und ein Laserprojektionsverfahren zur Projektion von Laserstrahlen auf eine Projektionsebene bekannt geworden. Hierbei ist eine steuerbare Multistrahl-Laserdiodeneinrichtung vorgesehen, deren Laserstrahlen mittels Ablenkeinrichtungen abgelenkt werden. Mit einer Steuereinrichtung werden die Ablenkeinrichtungen derart angesteuert, dass die abgelenkten Laserstrahlen auf der Projektionsebene entlang einer Abtastlinie sich bewegen, wobei unterschiedlich abgelenkte Laserstrahlen als getrennte Strahlen in der Projektionsebene auf derselben Abtastlinie verlaufen.

Aus US2016/0087393 A1 ist eine Lasereinheit in einem optischen Kommunikatinsnetzwerk bekannt geworden. Um Alterungsprozesse in den Laserdioden auszugleichen, werden deren LI-Kurven aufgenommen.

Aus US2016/0073071 A1 ist ein Head-Up Display bekannt, bei dem ein Laserstrahl über einen Spiegel auf eine Windschutzscheibe projiziert wird.

Der Erfindung liegt die Aufgabe zugrunde, eine Vorrichtung zur Laserprojektion bereitzustellen, die mit einfachen Mitteln eine gewünschte Intensität des Laserstrahls bereitstellt.

Erfindungsgemäß wird die Aufgabe durch eine Vorrichtung mit den Merkmalen aus Anspruch 1 gelöst. Vorteilhafte Ausgestaltungen bilden den Gegenstand der Unteransprüche.

Die erfindungsgemäße Vorrichtung ist vorgesehen und bestimmt zur Laserprojektion. Es handelt sich somit um einen Laserprojektor oder ein Laserprojektorsystem. Erfindungsgemäß sind zwei Laserdioden mit gleicher Wellenlänge vorgesehen. Die Strahlen der Laserdioden sind jeweils linear polarisiert, wobei die Polarisationsachsen oder -richtungen paarweise senkrecht aufeinander stehen. Ferner ist ein Polarisations-Combiner vorgesehen, der die einfallenden Strahlen der Laserdioden zu einem kombinierten Strahl mit zirkularer oder elliptischer Polarisation kombiniert. Hierbei wird ausgenutzt, dass die unterschiedlichen Polarisationen der einfallenden Strahlen zu einer zirkularen oder elliptischen Polarisation kombiniert werden können. Erfindungsgemäß ist ferner eine Messanordnung vorgesehen, die eine Intensität des kombinierten Laserstrahls misst. Der Messwert der Messanordnung ist also ein Maß für die Intensität des kombinierten Laserstrahls. Der gemessene Wert für die Intensität des kombinierten Laserstrahls liegt bevorzugt an einer Steuereinheit als Eingangssignal an. Die Steuereinheit stellt eine Intensität mindestens einer der Leuchtdioden ein. Das Einstellen kann beispielsweise manuell oder abhängig von dem anliegenden Eingangssignal erfolgen. Dies bedeutet, die erfindungsgemäße Vorrichtung kombiniert zwei bis auf ihre Polarisation identische Laserstrahlen zu einem kombinierten Laserstrahl und stellt über die Steuereinheit dessen Intensität ein.

Hierdurch entstehen eine Reihe von wichtigen Einsatzmöglichkeiten für den Laserprojektor, die sich aus der Anpassung der Intensität ergeben.

Erfindungsgemäß ist die Steuereinheit in einem Betriebsmodus dazu ausgebildet, bei einer nachlassenden Intensität des kombinierten Strahls die Leistung der mindestens einen einstellbaren Laserdiode zu erhöhen. In diesem Betriebsmodus ist sichergestellt, dass, falls eine der beiden Laserdioden in ihrer Leistung nachlässt oder vollständig ausfällt, die Intensität der anderen Laserdiode erhöht wird und so auch die Intensität des kombinierten Laserstrahls erhöht wird. Bei dem industriellen Einsatz des Laserprojektors ist dieser Betriebsmodus von besonderem Vorteil. Fällt eine der Laserdioden beispielsweise aus, kann ohne Unterbrechung des Betriebes die Projektion mit der anderen Laserdiode fortgesetzt werden. So ist ein kontinuierliches Arbeiten ohne Unterbrechung für einen Austausch der Laserdiode möglich.

In einer bevorzugten Weiterbildung erfolgt eine Regelung der Intensität des kombinierten Laserstrahls. Geregelt wird dessen Intensität auf einen Sollwert, der beispielsweise zeitlich konstant vorgegeben sein kann. Eine Regelung der Intensität schafft eine Reihe von Vorteilen für den praktischen Einsatz des Projektors. So kann beispielsweise ein Sollwert vorgegeben werden, der um einen bestimmen Wert unterhalb des aus Sicherheitsgründen zulässigen Maximalwerts liegt. In dieser Ausgestaltung wird der Laserprojektor mit der konstanten Leistung betrieben.

Erfindungsgemäß ist ein zweiter Betriebsmodus vorgesehen, der für Teile und/oder Abschnitte einer zu projizierenden Figur eine erhöhte oder verminderte Leistung des kombinierten Strahls vorsieht. Die zu projizierende Figur kann dabei eine zusammenhängende Figur sein, bei der Teile der Figur beispielsweise durch eine Erhöhung oder Verminderung der Leistung des kombinierten Laserstrahls optisch hervorgehoben oder zurückgenommen werden. Dies kann beispielsweise auch helfen, Montageschritte anzuzeigen, in denen beispielsweise schrittweise und nacheinander Teile oder Abschnitte der Figur hervorgehoben werden. Auch können in dem zweiten Betriebsmodus zu projizierende Konturen oder Konturabschnitte unterschiedlich dargestellt werden. Dies hat beispielsweise einen Vorteil, wenn für einen bestimmten Vorgang erst eine erste Kontur und dann eine zweite Kontur angezeigt werden soll.

Bevorzugt ist für den Laserprojektor eine maximal zulässige Laserleistung vorgesehen, die für den kombinierten Laserstrahl von einer Steuereinheit nicht überschritten wird. Herkömmlich kann sich eine maximal zulässige Laserleistung beispielsweise ohne weitere Maßnahmen allein aus der Bauart der Laserdiode ergeben. Bei der Verwendung von zwei Laserdioden, die miteinander kombiniert werden und daher mit unterschiedlichen Laserleistungen für den kombinierten Laserstrahl arbeiten können, ist es daher vorteilhaft, die maximal zulässige Laserleistung vorzugeben.

Für die Ansteuerung der Laserdioden kann beispielsweise eine Pulsweitenmodulation vorgesehen sein. Die Pulsweitenmodulation gibt dann die Ausgangsleistung der Laserdiode vor. Alternativ oder auch in Kombination mit der Pulsweitenmodulation, kann eine kontinuierliche Ansteuerung der Laserdiode vorgesehen sein.

Es hat sich als zweckmäßig erwiesen, wenn für jede Laserdiode eine einstellbare Fokuseinrichtung vorgesehen ist. Die Fokuseinrichtung wird in der Regel nicht während des Betriebs des Laserprojektors verwendet, sondern anfänglich einmal auf einen Abstand zur Projektionsfläche eingestellt.

Um eine besonders einfache und wirksame Ausrichtung der Laserdioden im Hinblick auf den Polarisations-Combiner zu erzielen, ist jede der Laserdioden dann auf eine Trägerplatte montiert, die auf einem gemeinsamen Grundträger befestigt ist. Somit können die Laserstrahlen der Laserdioden relativ zueinander über die separaten Trägerplatten ausgerichtet werden.

Für eine verbesserte Ausrichtung der Trägerplatten zueinander, ist eine erste Trägerplatte mit einem Langloch ausgestattet, das eine Ausrichtung der ersten Platte relativ zu einer zweiten Trägerplatte zulässt. Die zweite Trägerplatte ist beispielsweise bereits direkt fest auf dem Grundträger montiert und die erste Trägerplatte wird über das Langloch relativ zu der zweiten Trägerplatte ausgerichtet und ebenfalls, beispielsweise über eine Schraube, an dem Grundträger befestigt.

Projiziert wird bei dem erfindungsgemäßen Projektor über zwei Galvanometerspiegel, die den kombinierten Laserstrahl in jede Richtung lenken können.

Eine bevorzugte Ausgestaltung lenkt den kombinierten Laserstrahl über zwei Galvanometerspiegel um. Die Drehachsen der Spiegel schließen bevorzugt einen rechten Winkel ein. Hierdurch erfolgt eine X/Y-Ausrichtung des Laserstrahls, die es erlaubt, auf für den Laserstrahl zugänglichen Flächen mit dem Laserlicht Konturen, Markierungen und dergleichen zu projizieren.

Die Erfindung wird anhand eines Ausführungsbeispiels näher erläutert.

Es zeigen:
- Fig. 1: in einer perspektivischen Ansicht die Funktionsweise von zwei Laserdioden, die zu einem Überlagerungsstrahl zusammengefügt werden, und
- Fig. 2: das Prinzip der Strahlkombination mit Polarisation.

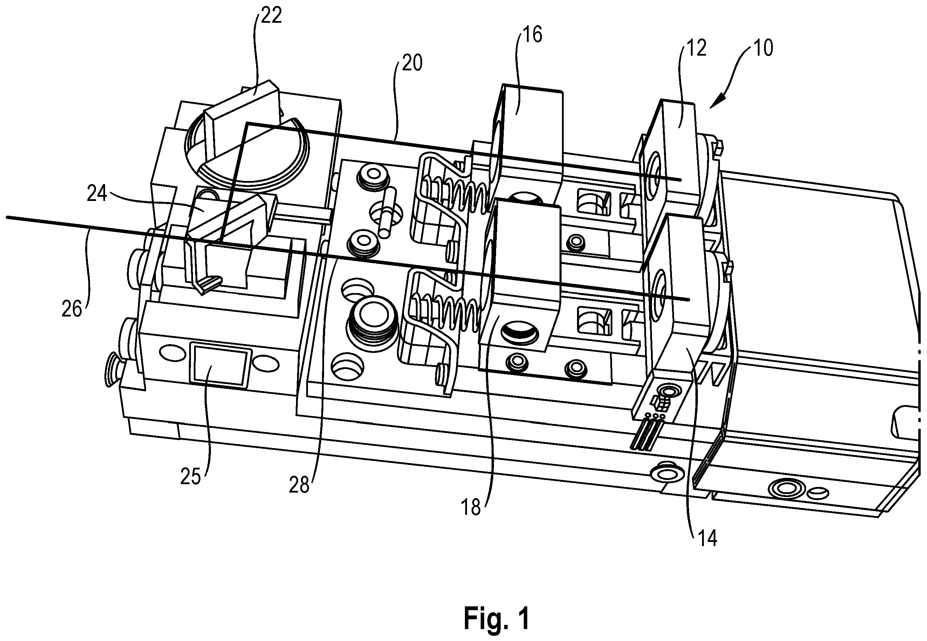

Figur 1 zeigt den Aufbau eines Laserprojektor 10 mit zwei Laserdioden 12, 14. Die Laserstrahlen der Laserdioden 12, 14 treten jeweils durch eine Fokussieroptik 16, 18 durch. Die Fokussieroptik 16, 18 ist jeweils auf einen Abstand zur Projektionsfläche eingestellt. Der Laserstrahl 20 der Laserdiode 12 trifft auf einen Spiegel 22 und wird zu dem Polarisations-Combiner 24 umgelenkt. Der durch die Fokussiereinheit 18 getretene Laserstrahl 28 trifft ebenfalls auf den Polarisations-Combiner 24 und trägt ebenfalls zu dem kombinierten Laserstrahl 26 bei. Die Messanordnung 25 für die Intensität des kombinierten Laserstrahls ist auf Höhe des Polarisations-Combiner 24 angeordnet und misst das "Abfall"-Licht des Strahls 20, das nicht zu dem kombinierten Laserstrahl 26 umgelenkt wird und das umgelenkte Licht des Strahls 28, das in dem Polarisations-Combiner 24 abgelenkt wird. Die Messanordnung kann eine Photodiode sein, die für die Wellenlänge des Laserlichts empfindlich ist.

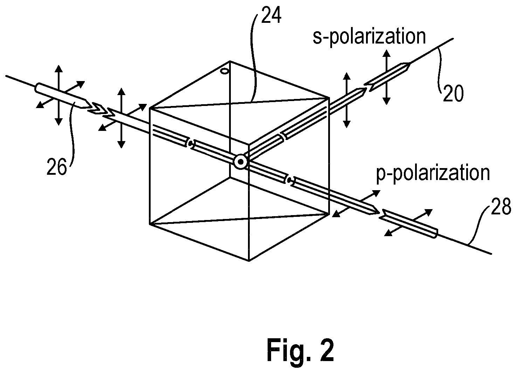

Figur 2 zeigt die prinzipielle Funktionsweise des Polarisations-Combiners. Der einlaufende Strahl 20 ist linear polarisiert mit einer sogenannten S-Polarisation. Der ebenfalls einlaufende Strahl 28 besitzt ebenfalls eine lineare Polarisation mit einer P-Polarisation. S- und P-Polarisation stehen senkrecht aufeinander. Der kombinierte Lichtstrahl 26 besitzt eine überlagerte Polarisation, die sich als eine zirkulare oder elliptische Polarisation darstellt.

Der Polarisations-Combiner ist bevorzugt mit einer Messeinrichtung ausgestattet, die die Intensität des kombinierten Laserstrahls 26 erfasst. Die erfasste Intensität wird an eine Steuereinheit weitergeleitet. Die Steuereinheit steuert die Laserdioden 12 und 14 an. Hierbei sind verschiedene Betriebsmodi zu unterscheiden: Beide Laserdioden 12, 14 besitzen die gleiche Wellenlänge und können einander ersetzen. Arbeitet der Laserprojektor mit einer der Laserdioden, beispielsweise der Laserdiode 14, so kann bei einem Nachlassen deren Helligkeit für die projizierte Figur manuell an der Steuereinheit zu der anderen Laserdiode 12 umgeschaltet werden. Die Steuereinheit führt bei dieser Ausgestaltung das manuelle Umschalten durch. In einer automatischen Ausgestaltung, schaltet die Steuereinheit, abhängig von dem anhängenden Eingangssignal, mit der nachlassenden Intensität des kombinierten Laserstrahls, automatisch auf die andere Laserdiode um. In diesem Fall braucht der Benutzer nicht einzugreifen und der Betrieb des Laserprojektors läuft automatisch weiter.

Die Steuereinheit kann mit einem zweiten Betriebsmodus ausgestattet sein. Der zweite Betriebsmodus schließt den ersten Betriebsmodus nicht notwendig aus. Der zweite Betriebsmodus erlaubt, die Helligkeit der Projektion in Projektionspunkten und -bereichen zu erhöhen. Hierzu wird die Intensität des kombinierten Laserstrahls erhöht. Besonders vorteilhaft ist hierbei, dass einem Benutzer, der beispielsweise durch die Projektion bei seinen Arbeitsschritten geleitet wird, hierdurch die Möglichkeit gegeben wird, einzelne Arbeitsschritte im Rahmen des Arbeitsablaufs hervorzugeben. Auch können andere Hervorhebungen, beispielsweise bei der Projektion von mehr als einer Kontur, auch einzelne Konturen heller hervorgehoben werden. Dies erhöht die Übersichtlichkeit bei der Verwendung des Laserprojektors.

### Bezugszeichenliste

- 10: Laserprojektor
- 12: Laserdiode
- 14: Laserdiode
- 16: Fokussieroptik
- 18: Fokussieroptik
- 20: Laserstrahl
- 22: Spiegel
- 24: Polarisations-Combiner
- 25: Messanordnung
- 26: kombinierter Laserstrahl
- 28: Laserstrahl

## Patentansprüche

1. Vorrichtung zur Laserprojektion von Umrissen und Markierungen auf Gegenständen, bei der über ein oder mehr Galvanometer ein Laserstrahl durch einen Spiegel abgelenkt wird, folgendes aufweisend:
• zwei Laserdioden (12, 14) mit gleicher Wellenlänge, deren Strahl linear polarisiert ist und deren Polarisationsachsen senkrecht zueinanderstehen, wobei jede Laserdiode (12, 14) auf einer Trägerplatte montiert ist, die jeweils auf einem gemeinsamen Grundträger angebracht ist,
• einen Polarisations-Combiner (24), der die Strahlen der Laserdioden (12, 14) zu einem kombinierten Strahl (26) mit zirkularer oder elliptischer Polarisation kombiniert,
• eine Messanordnung (25), die eine Intensität des kombinierten Laserstrahls (26) misst und
• eine Steuereinheit, an der die gemessene Intensität des kombinierten Laserstrahls (26) als Eingangssignal anliegt und die eine Intensität mindestens einer der Laserdioden (12, 14) einstellt,
• wobei die Steuereinheit in einem ersten Betriebsmodus bei einer nachlassenden Intensität des kombinierten Strahls (26) die Leistung der mindestens einen einstellbaren Laserdiode (12, 14) erhöht, und
• ein zweiter Betriebsmodus vorgesehen ist, der für Teile und/oder Abschnitte einer zu projizierenden Figur eine erhöhte oder verminderte Leistung des kombinierten Strahls (26) für die Projektion vorsieht, wobei der zweite Betriebsmodus dazu ausgelegt ist, zu projizierende Konturen oder Konturabschnitte unterschiedlich hell darzustellen.

2. Vorrichtung nach Anspruch 1, **dadurch gekennzeichnet, dass** die Steuereinheit die Intensität mindestens einer der Laserdioden (12, 14) abhängig von dem anliegenden Eingangssignal einstellt.

3. Vorrichtung nach einem der Ansprüche 1 bis 2, **dadurch gekennzeichnet, dass** die Steuereinheit die Intensität des kombinierten Strahls (26) auf einen Soll-Wert regelt.

4. Vorrichtung nach einem der Ansprüche 1 bis 3, **dadurch gekennzeichnet, dass** eine maximal zulässige Laserleistung vorgegeben ist, die von der Steuereinheit nicht überschritten wird.

5. Vorrichtung nach einem der Ansprüche 1 bis 4, **dadurch gekennzeichnet, dass** eine Ansteuerung der Laserdioden (12, 14) über eine Pulsweitenmodulation erfolgt.

6. Vorrichtung nach einem der Ansprüche 1 bis 5, **dadurch gekennzeichnet, dass** eine Ansteuerung der Laserdioden (12, 14) über eine kontinuierliche Ansteuerung erfolgt.

7. Vorrichtung nach einem der Ansprüche 1 bis 6, **dadurch gekennzeichnet, dass** für jede Laserdiode (12, 14) eine einstellbare Fokuseinrichtung (16, 18) vorgesehen ist,

8. Vorrichtung nach Anspruch 1, **dadurch gekennzeichnet, dass** eine erste Trägerplatte mit einem Langloch ausgestattet ist, das eine Ausrichtung der ersten Trägerplatte relativ zu einer zweiten Trägerplatte zulässt.

9. Vorrichtung nach einem der Ansprüche 1 bis 8, **dadurch gekennzeichnet, dass** der kombinierte Laserstrahl (26) über zwei Galvanometer-Spiegel umgelenkt werden.

## Claims

1. Device for laser projection of outlines and markings on objects, wherein a laser beam is deflected through a mirror via one or more galvanometers, comprising the following:
• two laser diodes (12, 14) with the same wavelength, whose beam is linearly polarized and whose polarization axes are perpendicular to each other, wherein each laser diode (12, 14) is mounted on a support plate, which is attached in each case to a common base support,
• a polarization combiner (24), which combines the beams of the laser diodes (12, 14) into a combined beam (26) with circular or elliptical polarization,
• a measuring arrangement (25), which measures an intensity of the combined laser beam (26) and
• a control unit, to which the measured intensity of the combined laser beam (26) is applied as an input signal and which adjusts an intensity of at least one of the laser diodes (12, 14),
• wherein the control unit in a first operating mode increases the power of the at least one adjustable laser diode (12, 14) at an attenuating intensity of the combined beam (26), and
• a second operating mode is provided, which provides an elevated or reduced power of the combined beam (26) for the projection for parts and/or sections of a figure to be projected, wherein the second operating mode is configured to display contours or contour sections to be projected with differing brightness.

2. Device according to claim 1, **characterized in that** the control unit adjusts the intensity of at least one of the laser diodes (12, 14) depending on the applied input signal.

3. Device according to one of claims 1 to 2, **characterized in that** the control unit regulates the intensity of the combined beam (26) to a setpoint.

4. Device according to one of claims 1 to 3, **characterized in that** a maximum permissible laser power is predetermined, which is not exceeded by the control unit.

5. Device according to one of claims 1 to 4, **characterized in that** a controlling of the laser diodes (12, 14) occurs via a pulse width modulation.

6. Device according to one of claims 1 to 5, **characterized in that** a controlling of the laser diodes (12, 14) occurs via a continuous controlling.

7. Device according to one of claims 1 to 6, **characterized in that** an adjustable focusing apparatus (16, 18) is provided for each laser diode (12, 14),

8. Device according to claim 1, **characterized in that** a first support plate is equipped with a slot that permits an alignment of the first support plate relative to a second support plate.

9. Device according to one of claims 1 to 8, **characterized in that** the combined laser beam (26) are redirected via two galvanometer mirrors.

## Revendications

1. Dispositif de projection laser de contours et de marquages sur des objets, dans lequel un faisceau laser est dévié par un miroir via un ou plusieurs galvanomètres, comprenant :
• deux diodes laser (12, 14) de même longueur d'onde, dont le faisceau est polarisé linéairement et dont les axes de polarisation sont perpendiculaires l'un à l'autre, chaque diode laser (12, 14) étant montée sur une plaque de support, qui est montée respectivement sur un support de base commun,
• un combineur de polarisation (24), qui combine les faisceaux des diodes laser (12, 14) en un faisceau combiné (26) présentant une polarisation circulaire ou elliptique,
• un ensemble de mesure (25), qui mesure une intensité du faisceau laser combiné (26) et
• une unité de commande, à laquelle est appliquée l'intensité mesurée du faisceau laser combiné (26) en tant que signal d'entrée, et qui règle une intensité d'au moins l'une des diodes laser (12, 14),
• dans lequel l'unité de commande augmente dans un premier mode de fonctionnement la puissance de ladite au moins une diode laser réglable (12, 14) lorsque l'intensité du faisceau combiné (26) diminue, et
• un second mode de fonctionnement est prévu, lequel prévoit, pour des parties et/ou des sections d'une figure à projeter, une puissance augmentée ou réduite du faisceau combiné (26) pour la projection, le second mode de fonctionnement étant conçu pour représenter des contours ou des sections de contours à projeter avec des intensités lumineuses variables.

2. Dispositif selon la revendication 1, **caractérisé en ce que** l'unité de commande règle l'intensité d'au moins l'une des diodes laser (12, 14) en fonction du signal d'entrée appliqué.

3. Dispositif selon l'une quelconque des revendications 1 à 2, **caractérisé en ce que** l'unité de commande règle l'intensité du faisceau combiné (26) sur une valeur de consigne.

4. Dispositif selon l'une quelconque des revendications 1 à 3, **caractérisé en ce qu'**une puissance laser maximale autorisée est définie, laquelle ne peut être dépassée par l'unité de commande.

5. Dispositif selon l'une quelconque des revendications 1 à 4, **caractérisé en ce qu'**une commande des diodes laser (12, 14) s'effectue par une modulation de largeur d'impulsion.

6. Dispositif selon l'une quelconque des revendications 1 à 5, **caractérisé en ce qu'**une commande des diodes laser (12, 14) s'effectue par une commande continue.

7. Dispositif selon l'une quelconque des revendications 1 à 6, **caractérisé en ce que** pour chaque diode laser (12, 14) est prévu un dispositif de focalisation réglable (16, 18),

8. Dispositif selon la revendication 1, **caractérisé en ce qu'**une première plaque de support est équipée d'un trou oblong qui permet un alignement de la première plaque de support par rapport à la seconde plaque de support.

9. Dispositif selon l'une quelconque des revendications 1 à 8, **caractérisé en ce que** le faisceau laser combiné (26) est redirigé par l'intermédiaire de deux miroirs de galvanomètre.
